# EUROPÄISCHE PATENTSCHRIFT

(11) **EP 1 727 221 B1**
(45) Veröffentlichungstag und Bekanntmachung des Hinweises auf die Patenterteilung: **14.04.2010**
(21) Anmeldenummer: 05011427.1
(22) Anmeldetag: 27.05.2005
(51) Int. Cl.: H01L 51/52

(54) **Transparente organische Leuchtdiode**
Transparent organic light emitting diode
Diode organique transparent émetteur de lumière

(43) Veröffentlichungstag der Anmeldung: 29.11.2006
(73) Patentinhaber: Novaled AG, 01307 Dresden (DE)
(72) Erfinder: Leo, Karl, Prof. Dr., 01219 Dresden (DE); Lyssenko, Vadim, Prof. Dr., 01069 Dresden (DE); Gehlhaar, Robert, 01219 Dresden (DE)
(74) Vertreter: Bittner, Thomas L.

(56) Entgegenhaltungen:
- WO-A-00/76008
- US-A- 6 046 543
- US-A1- 2004 066 824
- US-B1- 6 614 161
- M. A. MACLEOD: "Thin film optical films, 3rd edition" 2001, INSTITUTE OF PHYSICS , IOP, BOSTON * Seite 185 - Seite 191 *

## Beschreibung

Die Erfindung bezieht sich auf eine transparente organische Leuchtdiode (OLED).

### Stand der Technik

Organische Leuchtdioden haben sich in letzter Zeit sehr schnell entwickelt. Obwohl sie erst 1987 für aufgedampfte organische Materialien (vgl. Tang et al., Appl. Phys. Lett. 51 (12), 913 (1987)) für aus flüssiger Lösung aufgebrachte polymere Materialien (vgl. J.H. Burroughes et al., Nature 347, 6293 (1990)) entwickelt wurden, konnte in den letzten Jahren bereits exzellente Parameter für die Effizienz und Lebensdauern organischer Leuchtdioden erzielt werden. Insbesondere gelang es, für grün emittierende Leuchtdioden Effizienzen von über 80 Lumen / W zu erreichen (vgl. He et al., Appl. Phys. Lett. 85, 3911 (2004)). Auch für rot emittierende und blau emittierende organische Leuchtdioden konnten bereits vergleichsweise gute Werte erreicht werden.

Da auch die Lebensdauer dieser Systeme sehr schnell gewachsen ist und inzwischen Werte von 10.000 Stunden für einige Materialsysteme bereits deutlich überschritten hat, erscheinen organische Leuchtdioden auch für Anwendungen in Beleuchtungssystemen interessant. Die wesentlichen Vorteile der organischen Leuchtdioden sind neben der möglichen hohen Effizienz, die bereits heute diejenige von Glühbirnen überschreitet und in Zukunft möglicherweise die Effizienz von Leuchtstoffröhren erreicht, die Möglichkeit, eine großflächige Beleuchtungseinheit zu realisieren, wodurch sehr blendfreies und für viele Anwendung ideal geeignetes Licht erzeugt werden kann.

Der übliche Aufbau für organische Leuchtdioden umfaßt ein transparentes Substrat, meistens Glas, das mit einer transparenten Anode beschichtet wird, die häufig aus Indiumzinnoxid oder Indiumthinoxid (ITO) gebildet ist. Darauf werden aktive organische Schichten abgeschieden und anschließend noch eine metallische Kathode zur elektrischen Kontaktierung aufgebracht. Werden einige Volt Spannung zwischen der metallischen Kathode und der transparenten Anode angelegt, so emittiert die Leuchtdiode durch das Substrat das Licht.

Es gibt auch technische Ansätze, die es erlauben, Leuchtdioden zu konstruieren, die zumindest teilweise transparent sind. Dazu kann beispielsweise die Kathode ebenfalls mit einem transparenten leitfähigem Metall oder mit einer dünnen, teilweise transparenten Metallschicht versehen werden (vgl. Gu et al., Appl. Phys. Lett. 68, 2606 (1996); Parthasaray et al., Appl. Phys. Lett. 76, 2128 (2000)). In den bisher vorgeschlagenen Anordnungen wird das Licht der Leuchtdiode dann in beide Richtungen emittiert, wobei das genaue Verhältnis der in die beiden Richtungen ausgestrahlten Lichtmengen vom Aufbau der Schichtanordnung abhängt. Dies ist für manche Anwendungen brauchbar, beispielsweise für Displays, die von beiden Seiten gelesen werden sollen.

Für Beleuchtungsanwendungen hingegen ist es oft nachteilig, wenn eine transparente Leuchtdiode in beide Seiten emittiert. Andererseits wäre es sehr günstig, wenn es möglich wäre, organische Leuchtdioden zu realisieren, die transparent sind und gleichzeitig deutlich bevorzugt in eine Richtung emittieren. Bei den aus der Literatur bekannten Ansätzen sind die Leuchtstärken in beiden Richtungen annähernd gleich (vgl. Gu et al., Appl. Phys. Lett. 68, 2606 (1996); Parthasaray et al., Appl. Phys. Lett. 76, 2128 (2000))

US 6,046,543 beschreibt eine invertierte organische Leuchtdiode, bei der ein dieelektrischer Filter zwischen OLED und Substrat angeordnet wird, um die Reflexion des Substrats spektral zu kontrollieren. Es ist nach der dort beschriebenen Anordnung auch möglich, ein transparentes Substrat zu verwenden und damit eine transparente OLED zu erzielen, die vorzugsweise in eine Richtung abstrahlt.

WO 00/76008 beschreibt eine organische Leuchtdiode, die durch Löcher im Substrat strukturierte Emitterschichten aufweist und mit einem dielektrischen Reflektor kombiniert werden kann.

US 2004/066,824 A1 beschreibt ein lichtemitterendes Element, das insbesondere dielektrische Spiegel als Rückkopplungsschichten verwendet. Diese Schichten können lateral strukturiert sein, um in Verbindung mit einem breitbandigen Emitter mehrere spektrale Anteile des breitbandigen Emitters zu reflektieren.

Das Buch mit dem Titel "Thin film optical films" von Macleod, 3. Edition, Institute of Physics, IOP, Boston beschreibt auf den Seiten 184 bis 193 die physikalischen Grundlagen von Reflexionen in dielektrischen Schichten.

### Die Erfindung

Aufgabe der Erfindung ist es, eine transparente organische Leuchtdiode zu schaffen, welche für Beleuchtungszwecke besser geeignet ist.

Diese Aufgabe wird durch die transparente organische Leuchtdiode nach Anspruch 1 gelöst. Vorteilhafte Ausgestaltungen der Erfindung sind Gegenstand von abhängigen Unteransprüchen.

Mit Hilfe der Erfindung ist es ermöglicht, einerseits im ausgeschalteten Zustand der transparenten organischen Leuchtdiode eine hohe optische Transparenz im sichtbaren Spektralbereich zu erzielen. Andererseits kann die Leuchtdiode im eingeschalteten Zustand weißes oder auch farbiges Licht präferentiell in eine Richtung emittieren, wobei ein Verhältnis von etwa 4:1 erreicht oder überschritten wird. Bei der vorgeschlagenen Leuchtdiode ist eine Integration einer lichtemittierenden Schichtanordnung mit einem Stapel dielektrischer Schichten vorgesehen. Mit Hilfe dieser Anordnung werden die Wellenlängen des in der lichtemittierenden organischen Schicht erzeugten Lichtes bevorzugt in eine Richtung emittiert.

Der Stapel dielektrischer Schichten ist bei einer Ausführungsform so gestaltet, dass in einem begrenzten Spektralbereich, der mit dem Emissionssprektrum des in der lichtemittierenden organischen Schicht erzeugten Lichtes zumindest teilweise überlappt, ein hohes Reflexionsvermögen (>90%) aufweist, wobei ein Reflexionsvermögen von >99% ausbildbar ist mit mehreren Schichten. Hierdurch wird ein wesentlicher Teil des in der lichtemittierenden organischen Schicht, welche ihrerseits als Schichtfolge gebildet sein kann, erzeugten Lichtes nur in eine Richtung emittiert, also bevorzugt durch die obere oder die untere Elektrode.

Gleichzeitig ist die Transmission der Leuchtdiode im gesamten sichtbaren Spektralbereich sehr hoch. Dies kann beispielsweise dadurch erreicht werden, dass der Stapel dielektrischer Schichten so ausgelegt wird, dass das Reflexionsband so schmal ist, dass nur die wesentlichen Teile der Emission der lichtemittierenden organischen Schicht reflektiert werden. Die Auslegung des Stapels dielektrischer Schichten kann dadurch neben den λ/4-Schichten, die in der einfachsten Form einer solchen spiegelnden Anordnung verwendet werden, auch mehrfache dieser Dicke für eine oder beide Teilkomponenten des Schichtstapels enthalten, wodurch die spektrale Reflexionsbreite reduziert wird (vgl. Macleod, Thin Film Optical Filters, 3rd ed., IOP Publishing 2001). Um eine möglichst hohe Transmission zu erreichen, ist die Schichtdicke des üblicherweise verwendeten transparenten Kontaktmaterials Indiumzinnoxid (ITO) optimiert; Rechnungen ergeben beispielsweise, dass dies für die Schichtdicke λ/4 der Fall ist.

Der Stapel dielektrischer Schichten reflektiert nicht nur eine Wellenlänge sondern bevorzugt mehrere, schmale Wellenlängenbereiche. Dies kann entweder mittels der sequentiellen Abscheidung mehrerer Stapel mit verschiedenen Dicken der Einzelschichten oder mittels Ausnutzung der höheren Reflektionsordnungen eines einfachen Schichtstapels erreicht werden. Hierdurch ist beispielsweise möglich, auch eine weiß emittierende transparente organische Leuchtdiode zu realisieren.

Das hier vorgeschlagene Prinzip ist sehr allgemein anwendbar und ist zum Beispiel von der genauen Natur der Schichtanordnung unabhängig. Beispielsweise ist es sowohl für aus der Lösung aufgebrachte als auch für im Vakuum aufgedampfte Schichtanordnungen verwendbar. Weiterhin kann es auch für organische Leuchtdioden verwendet werden, wenn diese in einem Stapel aus zwei oder mehreren Dioden monolithisch integriert sind. Das abgestrahlte Licht wird in diesem Fall mit Hilfe mehrerer organischer Leuchtdioden erzeugt.

### Ausführungsbeispiele der Erfindung

Die Erfindung wird im folgenden anhand von Ausführungsbeispielen unter Bezugnahme auf Figuren einer Zeichnung näher erläutert. Hierbei zeigen:
- Fig. 1: eine schematische Darstellung einer transparenten Schichtanordnung für eine transparente organische Leuchtdiode; und
- Fig. 2: ein Transmissionsspektrum für eine Ausführungsform einer Schichtanordnung nach Fig. 1.

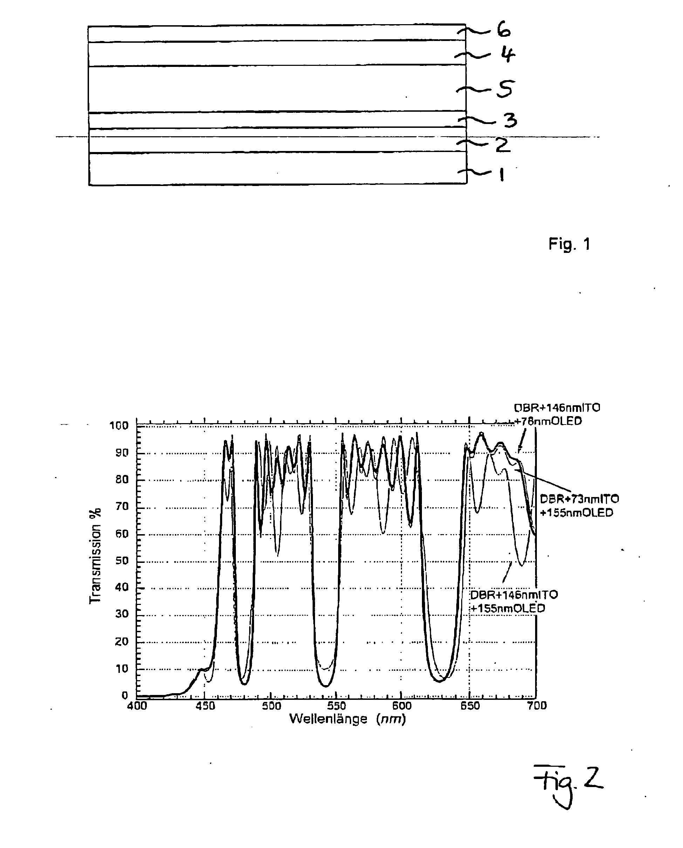

Fig. 1 zeigt eine schematische Darstellung einer transparenten Schichtanordnung für eine transparente organische Leuchtdiode (OLED). Auf einem Substrat 1 ist ein Stapel 2 dielektrischer Schichten angeordnet, der auf eine untere transparente Elektrode 3 folgt. Gegenüber der unteren Elektrode 3 ist eine obere transparente Elektrode 4 angeordnet. Zwischen der unteren und der oberen Elektrode 3, 4 ist ein organischer Bereich 5 angeordnet.

Der organische Bereich 5 ist aus einem oder mehreren organischen Materialien gebildet und enthält mindestens eine lichtemittierende organische Schicht, in welcher beim Anlegen einer elektrischen Spannung an die untere und die obere Elektrode 3, 4 Licht erzeugt wird. Die lichtemittierende organische Schicht ist wahlweise als Einzelschicht oder Folge von Schichten gebildet, wie dieses in verschiedenen Ausführungen für organische Leuchtdioden bekannt ist. In ähnlicher Weise kann der organische Bereich 5 weitere organische Schichten umfassen, beispielsweise dotierte oder undotierte Löcher- oder Elektronentransportschichten. Auch Zwischenschichten können vorgesehen sein. Den Abschluss der transparenten Schichtanordnung bildet eine Kapselung 6, die zum Ausschluss von Umwelteinflüssen dient.

Eine vorteilhafte Ausführung einer Schichtanordnung nach Fig. 1 für eine transparente organische Leuchtdiode umfaßt die folgenden Schichten / Schichtfolgen:
1. Träger, Substrat
2. Stapel aus im sichtbaren Spektralbereich transparenten Materialien (Dielektrika), beispielsweise fünf Schichten SiO₂/TiO₂ mit einer Dicke von jeweils λ/4
3. transparente Elektrode, beispielsweise ITO, Löcher injizierend (Anode)
3. p-dotierte, Löcher injizierende und transportierende Schicht
4. lichtemittierende organische Schicht (wahlweise mit Emitterfarbstoff dotiert)
5. n-dotierte, Elektronen injizierende und transportierende Schicht,
6. transparente Elektrode, Elektronen injizierend (Kathode),
7. Kapselung zum Ausschluß von Umwelteinflüssen.

Für die Realisierung einer transparenten organischen Leuchtdioden, die in zwei oder drei Wellenlängenbereichen emittiert, können zum einen mehrere Stapel dielektrischer Schichten mit der jeweiligen Einzelschichtdicke λ/4 übereinander gelegt werden. Hierdurch werden jeweilige spektrale Bänder reflektiert und geben in der Überlagerung das gewünschte Spektrum des emittierten Lichtes.

Eine weitere Möglichkeit besteht darin, höhere Ordnungen eines periodischen Stapels dielektrischer Schichten zu nutzen. Da bei einer λ/4-Anordnung diese höheren Ordnungen jeweils bei der halben Wellenlänge der nächstniedrigen Ordnung liegen, könnte so innerhalb des sichtbaren Spektralbereichs kaum eine Überlagerung mehrer Banden erreicht werden. Werden jedoch für die längste zu überlagernde Wellenlänge bereits Vielfache von λ/4-Schichtdicken verwendet, so können von einem Stapel dielektrischer Schichten mit einheitlichen Schichtdicken mehrere Spektralbereiche innerhalb des sichtbaren Lichts überlagert werden.

Ein bevorzugtes Ausführungsbeispiel zeigt die in Fig. 2 dargestellten Transmissionsspektren und weist den folgenden Aufbau auf:
1. Träger, Substrat, Glas
2. Stapel dielektrischer Schichten ("Distributed Bragg Reflector", DBR) aus im sichtbaren Spektralbereich transparenten Materialien (Dielektrika) mit drei Doppelschichten SiO2/TiO2 mit einer Dicke von jeweils 13λ/4
3. transparente Elektrode, beispielsweise ITO, Löcher injizierend (Anode), Dicke 146nm (dicke durchgezogene und gepunktete Linie in Fig. 2) oder 73nm (dünne durchgezogene Linie in Fig.2)
3. p-dotierte, Löcher injizierende und transportierende Schicht
4. lichtemittierende Schicht (wahlweise mit Emitterfarbstoff dotiert)
5. n-dotierte Elektronen injizierende und transportierende Schicht
6. transparente Elektrode, Elektronen injizierend (Kathode)
7. Kapselung zum Ausschluß von Umwelteinflüssen.

Fig. 2 zeigt das Transmissionsspektrum einer solchen Anordnung, wobei die Kapselung in der optischen Modellierung nicht berücksichtigt ist. Die Gesamtdicke der organischen Schichten 3. bis 5. wurde mit 78nm (dicke durchgezogene Linie) oder 155nm (gepunktete und dünne durchgezogene Linie) angesetzt, die Schichten 6. und 7. wurden als eine λ/4-Schicht mit dem Brechungsindex 1,38 modelliert. Es ergibt sich, dass diese Anordnung bei etwa 630nm, 540nm und 480nm jeweils eine hohe Reflexion zeigt. Auf diese Weise kann mit einer solchen Anordnung eine stark asymmetrische Emission erzielt werden, obwohl die gesamte Transmission noch größer als 60% ist.

Die in der vorstehenden Beschreibung, den Ansprüchen und den Zeichnungen offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Transparente organische Leuchtdiode mit einer Schichtanordnung, in welcher zwischen einer oberen und einer unteren Elektrode eine lichtemittierende organische Schicht angeordnet ist, wobei die Schichtanordnung in einem ausgeschalteten Zustand transparent und in einem eingeschalten Zustand mittels Anlegen einer elektrischen Spannung an die obere und die untere Elektrode in der lichtemittierenden organischen Schicht erzeugtes Licht emittiert, welches in einem Verhältnis von mindestens etwa 4:1 durch die obere oder die untere Elektrode abgestrahlt wird, und wobei auf der Seite der oberen oder der unteren Elektrode ein im sichtbaren Spektralbereich transparenter Stapel dielektrischer Schichten aus zwei oder mehr Materialien mit unterschiedlichen Brechungsindizes angeordnet ist, **dadurch gekennzeichnet, dass** der Stapel dielektrischer Schichten mit mehreren verschiedenen spektralen Komponenten des in der lichtemittierenden organischen Schicht erzeugten Lichtes entsprechenden Reflexionsbändern gebildet ist, indem die Reflexionsbänder unterschiedliche Reflexionsordnungen des Stapels dielektrischer Schichten nutzend gebildet sind, wobei eine jeweilige Schichtdicke der dielektrischen Schichten n x λ/4 (n = 1, 2, ...; λ - Wellenlänge des emittierten Lichtes) beträgt.

2. Transparente organische Leuchtdiode nach Anspruch 1, **dadurch gekennzeichnet, dass** das Emissionsspektrum des in der lichtemittierenden organischen Schicht erzeugten Lichtes und ein spektraler Reflexionsbereich des Stapels dielektrischer Schichten, in welchem der Stapel dielektrischer Schichten ein hohes Reflexionsvermögen (>90%) aufweist, zumindest teilweise überlappend ausgebildet sind.

3. Transparente organische Leuchtdiode nach Anspruch 1 oder 2, **dadurch gekennzeichnet, dass** der Stapel dielektrischer Schichten direkt auf die obere oder die untere Elektrode aufgebracht ist.

4. Transparente organische Leuchtdiode nach einem der vorangehenden Ansprüche, **dadurch gekennzeichnet, dass** die lichtemittierende organische Schicht als eine Schichtfolge mit mehreren Schichten gebildet ist.

5. Transparente organische Leuchtdiode nach einem der vorangehenden Ansprüche, **dadurch gekennzeichnet, dass** die Schichtanordnung Weißlicht emittierend gebildet ist, wobei das Weißlicht aus mehreren spektralen Komponenten des in der lichtemittierenden organischen Schicht erzeugten Lichtes zusammengesetzt ist.

6. Transparente organische Leuchtdiode nach einem der vorangehenden Ansprüche, **dadurch gekennzeichnet, dass** die lichtemittierende organische Schicht in einer organischen Leuchtdiode gebildet ist und dass mindestens eine weitere organische Leuchtdiode mit einer weiteren lichtemittierenden organischen Schicht gebildet ist, wobei die organische Leuchtdiode und die mindestens eine weitere organische Leuchtdiode übereinander gestapelt sind.

## Claims

1. Transparent organic light-emitting diode with a layer arrangement in which a light-emitting organic layer is arranged between an upper and a lower electrode, the layer arrangement being transparent in a switched-off state and emitting light which is produced in the light-emitting organic layer by applying an electrical voltage to the upper and the lower electrode in a switched-on state, which light is radiated in a ratio of at least approximately 4:1 through the upper or the lower electrode, and wherein a stack, which is transparent in the visible spectral region, of dielectric layers of two or more materials with different refractive indices is arranged on the side of the upper or the lower electrode **characterized in that** the stack of dielectric layers is formed with a plurality of different spectral components corresponding to reflection bands of the light which is produced in the light-emitting organic layer as the reflection bands are formed using different reflection orders of the stack of dielectric layers, wherein a respective layer thickness of the dielectric layers is n × λ/4, wherein n= 1, 2, ... and λ is the wavelength of the emitted light.

2. Transparent organic light-emitting diode according to Claim 1, **characterized in that** the emission spectrum of the light which is produced in the light-emitting organic layer and a spectral reflection region of the stack of dielectric layers, in which the stack of dielectric layers has a high reflecting power (>90%), are formed so as to be at least partly overlapping.

3. Transparent organic light-emitting diode according to Claim 1 or 2, **characterized in that** the stack of dielectric layers is applied directly to the upper or the lower electrode.

4. Transparent organic light-emitting diode according to any one of the preceding Claims, **characterized in that** the light-emitting organic layer is formed as a layer sequence with a plurality of layers.

5. Transparent organic light-emitting diode according to any one of the preceding Claims, **characterized in that** the layer arrangement is formed to emit white light, the white light being composed of a plurality of spectral components of the light which is produced in the light-emitting organic layer.

6. Transparent organic light-emitting diode according to any one of the preceding Claims, **characterized in that** the light-emitting organic layer is formed in an organic light-emitting diode, and that at least one further organic light-emitting diode with a further light-emitting organic layer is formed, the organic light-emitting diode and the at least one further organic light-emitting diode being stacked one on top of the other.

## Revendications

1. Diode électroluminescente organique transparente avec un arrangement de couches, dans laquelle est disposée entre une électrode supérieure et une électrode inférieure une couche organique électroluminescente, l'arrangement de couches étant transparent à un état éteint et, à un état allumé, émet de la lumière générée dans la couche organique électroluminescente par application d'une tension électrique à l'électrode supérieure et l'électrode inférieure, lumière qui est rayonnée à un rapport d'au moins environ 4:1 à travers l'électrode supérieure et l'électrode inférieure, et une pile transparente dans la plage spectrale visible de couches diélectriques de deux matériaux ou plus d'indices de réfraction différents étant disposée du côté de l'électrode supérieure et l'électrode inférieure, **caractérisée en ce que** la pile de couches diélectriques est formée avec des bandes de réflexion correspondant à plusieurs composantes spectrales différentes de la lumière générée dans la couche organique électroluminescente, les bandes de réflexion étant formées de manière à utiliser différents ordres de réflexion de la pile de couches diélectriques, étant donné que chaque épaisseur de couches diélectriques est égale à n x λ/4 (n = 1, 2, ... ; λ - longueur d'onde de la lumière émise).

2. Diode électroluminescente organique transparente selon la revendication 1, **caractérisée en ce que** le spectre d'émission de la lumière générée dans la couche organique électroluminescente et une plage de réflexion spectrale de la pile de couches diélectriques, dans laquelle la pile de couches diélectriques présente une grande capacité de réflexion (> 90 %), se chevauchent au moins partiellement.

3. Diode électroluminescente organique transparente selon la revendication 1 ou 2, **caractérisée en ce que** la pile de couches diélectriques est directement appliquée sur l'électrode supérieure ou l'électrode inférieure.

4. Diode électroluminescente organique transparente selon l'une quelconque des revendications précédentes, **caractérisée en ce que** la couche organique électroluminescente est formée comme séquence de couches avec plusieurs couches.

5. Diode électroluminescente organique transparente selon l'une quelconque des revendications précédentes, **caractérisée en ce que** l'arrangement de couches est formée de manière à émettre de la lumière blanche, la lumière blanche étant composée de plusieurs composantes spectrales de la lumière générée dans la couche organique électroluminescente.

6. Diode électroluminescente organique transparente selon l'une quelconque des revendications précédentes, **caractérisée en ce que** la couche organique électroluminescente est formée dans une diode électroluminescente organique et **en ce qu'**au moins une autre diode électroluminescente organique est formée avec une autre couche organique électroluminescente, la diode électroluminescente organique et l'autre (les autres) diode(s) électroluminescente(s) organique(s) étant empilées.
